# EUROPÄISCHE PATENTANMELDUNG

(11) **EP 0 601 392 A2**
(43) Veröffentlichungstag der Anmeldung: **15.06.1994**
(21) Anmeldenummer: 93118939.3
(22) Anmeldetag: 24.11.1993
(51) Int. Cl.: G11C 29/00

(54) **Verfahren zum Testen des Übersprechverhaltens von digitalen Speichern**

(30) Priorität: 08.12.1992 DE 4241337
(71) Anmelder: SIEMENS AKTIENGESELLSCHAFT, D-80333 München (DE)
(72) Erfinder: Müller, Gerd, Dipl.-Ing., D-09131 Chemnitz (DE)

(57) **Zusammenfassung**

Bei einem Verfahren zum Testen des Übersprechverhaltens von digitalen Speichern (SP) wird zunächst in aufsteigender und dann in absteigender Reihenfolge jede Speicherzelle bezüglich des eingeschriebenen Bit-Musters überprüft und unmittelbar darauf mit dem Komplementärmuster beschrieben, welches dann in der gleichen Reihenfolge überprüft wird. Damit läßt sich die Zahl der benötigten Schreib- und Prüfvorgänge auf 5n bzw. 4n reduzieren.

## Beschreibung

Die Erfindung betrifft das Gebiet der Datenverarbeitung und bezieht sich auf die Testung von Schreib-Lesespeichern bei der Schaltkreisherstellung und -anwendung.

Moderne Datenverarbeitungsanlagen benötigen immer größere Schreib-Lesespeicher. Diese Speicher müssen zu verschiedenen Zeitpunkten einer Funktionskontrolle unterzogen werden. Ein möglicher Speicherfehler, das sogenannte Übersprechen, besteht darin, daß beim gezielten Ändern des Inhaltes einer Speicherzelle sich der Inhalt einer anderen Speicherzelle ebenfalls ändert. Zur Feststellung dieses Fehlers ist ein Übersprechtest erforderlich. Dieser Test hat folgendes zu überprüfen: Übersprechen auf jede Speicherzelle mit niedriger Adresse, Übersprechen auf jede Speicherzelle mit höherer Adresse, Übersprechen bei Änderung des Zustandes von logisch "0" auf logisch "1" und umgekehrt.

Bei einer bekannten Lösung wird der gesamte Speicher mit dem gleichen Muster und eine einzelne Speicherzelle mit dem Komplementmuster beschrieben. Danach werden alle übrigen Speicherzellen auf Veränderungen überprüft und die veränderte Speicherzelle wird rückgeändert. Dieser Test muß mit jeder Speicherzelle wiederholt werden. Danach wird das Muster und das Komplementmuster getauscht und der gesamte Test wiederholt.

Bei einer weiteren bekannten Lösung wird der gesamte Speicher mit dem gleichen Muster beschrieben. Es werden nacheinander über den gesamten Speicher jeweils jede erste von zwei Speicherzellen, die ersten zwei von vier Speicherzellen, die ersten vier von acht Speicherzellen usw., bis zur gesamten ersten Hälfte des Speichers mit einem Komplementmuster beschrieben, die unveränderten Speicherzellen werden überprüft und die geänderten Speicherzellen wieder auf das Ursprungsmuster rückgeändert. Im darauffolgenden Test wird umgekehrt vorgegangen. Es werden die jeweils zweite von zwei Speicherzellen, die letzten zwei von vier Speicherzellen, die letzten vier von acht Speicherzellen usw, bis zur letzten Speicherhälfte geändert, die unveränderten Speicher überprüft und die veränderten wieder rückgeändert. Nach Austausch von Muster und Komplementmuster ist auch hier der gesamte Test zu wiederholen.

Die bekannten Verfahren haben den Nachteil, daß die benötigte Testzeit, bedingt durch die Zahl der Schreib- und Prüfvorgänge, überproportional mit der Größe des Speichers zunimmt. Bei n Speicherzellen ergeben sich bei der ersten bekannten Lösung 6n Schreibvorgänge und 2n² Prüfvorgänge und bei der Zweiten bekannten Lösung 4n x 1dn Schreibvorgänge und 2n x 1dn Schreibvorgänge.

Aufgabe der Erfindung ist es, die Testzeit für digitale Speicher zu senken.

Diese Aufgabe wird durch das im Hauptanspruch angegebene Verfahren gelöst, wobei die Verfahrensschritte entsprechend den Unteransprüchen variiert werden können.

Die Erfindung wird im folgenden anhand einer Zeichnung erläutert.

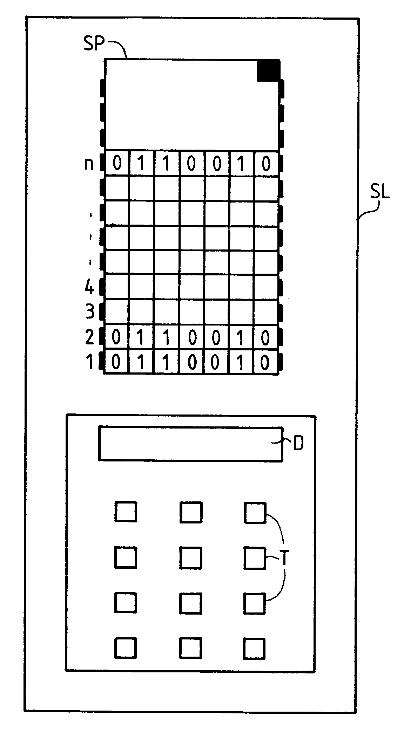

Die Zeichnung zeigt ein Schreib-Lesegerät SL zum Testen von digitalen Speichern. Das Schreib-Lesegerät SL verfügt über eine Eingabetastatur T und ein Display D. Außerdem ist ein Speicherbaustein SB aufgesteckt, der über die Speicherzellen 1...n verfügt. Zum Testen der Funktion des Speicherbausteins SB wird über die Tastatur T mit Hilfe des Displays D ein binäres Muster eingegeben. Jede Speicherzelle des zu prüfenden Speichers wird dann vom Schreib-Lesegerat SL mit diesem Bit-Muster beschrieben. Beginnend von der ersten Speicherzelle wird dann jede weiterer Speicherzelle zuerst auf das eingegebenen Bit-Muster überprüft und danach auf das Komplementärmuster, daß vom Schreib-Lesegerät SL automatisch gebildet wird, verändert. Daraufhin wird beginnend von der ersten Speicherzelle jede Speicherzelle zuerst auf das Komplementärmuster überprüft und danach wieder auf das ursprünglich eingegebene Bit-Muster rückgeändert. Der anschließende Testvorgang beginnt bei der letzten Speicherzelle, also bei der Speicherzelle n, wobei jede Speicherzelle zuerst auf das ursprünglich eingegebene Bit-Muster überprüft wird und danach auf das Komplementärmuster geändert wird. Daraufhin wird, beginnend bei der letzten Speicherzelle wieder jede Speicherzelle zuerst bezüglich des Komplementärmusters überprüft und danach auf das Ursprungsmuster geändert.

Bei diesem Verfahren ist die Anzahl der Schreib- und Prüfvorgänge und somit die Testzeit proportional zur Zahl der Speicherzellen. Je größer die Speicher werden, desto größer wird der Vorteil dieses Verfahrens gegenüber den eingangs geschilderten bekannten Lösungen. Bei n Speicherzellen ergeben sich lediglich 5n Schreibvorgänge und 4n Prüfvorgänge.

Falls vor dem Übersprechtest bereits schon ein anderer Speichertest, z.B. ein Datenleitungstest oder ein Adreßtest erfolgt ist und dieser Test ein einheitliches Muster im Speicher hinterlassen hat, kann auf den ersten Schritt des Übersprechtestes verzichtet werden. Die Anzahl der Schreibvorgänge reduziert sich damit auf 4n.

## Patentansprüche

1. Verfahren zum Testen des Übersprechverhaltens von digitalen Speichern mit folgenden Schritten:
1.1 der gesamte Speicher wird mit dem gleichen binären Muster beschrieben
1.2 beginnend von der ersten Speicherzelle wird jede Speicherzelle zuerst auf das binäre Muster überprüft und danach auf das Komplementmuster verändert
1.3 beginnend von der ersten Speicherzelle wird jede Speicherzelle zuerst auf das Komplementmuster überprüft und danach auf das binäre Muster rückgeändert
1.4 beginnend ab der letzten Speicherzelle wird jede Speicherzelle zuerst auf das binäre Muster überprüft und danach auf das Komplementmuster geändert
1.5 beginnend ab der letzten Speicherzelle wird jede Speicherzelle auf das Komplementmuster überprüft und danach auf das Ursprungsmuster rückgeändert.

2. Verfahren nach Anspruch 1, wobei die Verfahrensschritte in der Reihenfolge 1.1, 1.2, 1.5, 1.4, 1.3 durchgeführt werden.

3. Verfahren nach Anspruch 1, wobei die Verfahrensschritte in der Reihenfolge 1.1, 1.4, 1.5, 1.2, 1.3 durchgeführt werden.

4. Verfahren nach Anspruch 1, wobei die Verfahrensschritte in der Reihenfolge 1.1, 1.4, 1.3, 1.2, 1.5 durchgeführt werden.
